# EUROPEAN PATENT APPLICATION

(11) **EP 4 776 390 A1**
(43) Date of publication of application: **15.07.2026**
(21) Application number: 25861733.1
(22) Date of filing: 09.05.2025
(51) Int. Cl.: H01M 10/658, H05K 7/20

(54) **BATTERY APPARATUS, ENERGY STORAGE APPARATUS, AND ELECTRICAL APPARATUS**

(30) Priority: 09.10.2024 CN 202411399900
(71) Applicant: Contemporary Amperex Technology Co., Limited, Ningde, Fujian 352100 (CN)
(72) Inventor: YANG, Zhouwei, Ningde, Fujian 352100 (CN); LI, Honglei, Ningde, Fujian 352100 (CN)
(74) Representative: Kraus & Lederer PartGmbB
(86) International application number: PCT/CN2025/094087
(87) International publication number: WO 2026/076940

(57) **Abstract**

The present application is applicable to the field of battery technologies, and provides a battery device (100), an energy storage device, and an electric device. The battery device includes: a box body (10); a battery cell (20), accommodated in the box body; and an electric control assembly (30), accommodated in the box body. The electric control assembly includes a bracket (31) and an electric control component. The bracket includes a bracket body (311). A side that is of the bracket body and that faces the battery cell is connected to a protruding structure (312), and a side that is of the bracket body and that is away from the battery cell is provided with the electric control component. The electric control assembly further includes a heat insulation plate (32) disposed on the side that is of the bracket body and that faces the battery cell. The heat insulation plate, the bracket body, and the protruding structure enclose to form a cavity. In the battery device provided in embodiments of the present application, the protruding structure is disposed on the side that is of the bracket body and that faces the battery cell, and the heat insulation plate, the protruding structure, and the bracket body enclose to form the cavity, so that the cavity and the heat insulation plate jointly function to hinder heat transfer and provide a heat insulation effect.

## Description

The present application claims the priority of Chinese Patent Application No. 202411399900.8, filed with the China National Intellectual Property Administration on October 9, 2024, entitled "Battery Device, Energy Storage Device, and Electric Device", the entire content of which is incorporated herein by reference.

### TECHNICAL FIELD

The present application relates to the field of battery technologies, and in particular, to a battery device, an energy storage device, and an electric device.

### BACKGROUND

Energy conservation and emission reduction are the key to the sustainable development of the automotive industry, and electric vehicles have become an important component of the sustainable development of the automotive industry due to energy saving and environment protection advantages thereof. For electric vehicles, battery technology is an important factor for the development thereof.

Due to the limited space in a battery device, an electric control assembly or another electric control assembly of the battery device is usually located close to a battery cell. During a charging and discharging process of the battery cell, especially in a case of thermal runaway, a relatively high temperature is easily generated, and damage to the electric control assembly or another electric control assembly is easily caused.

### SUMMARY

In view of the foregoing problem, the present application provides a battery device, an energy storage device, and an electric device, to alleviate a problem that a high temperature generated by a battery cell easily causes damage to an electric control assembly.

According to a first aspect, an embodiment of the present application provides a battery device, including: a box body; a battery cell, accommodated in the box body; and an electric control assembly, accommodated in the box body. The electric control assembly comprises a bracket and an electric control component. The bracket comprises a bracket body. A side that is of the bracket body and that faces the battery cell is connected to a protruding structure, and a side that is of the bracket body and that is away from the battery cell is provided with the electric control component. The electric control assembly further comprises a heat insulation plate disposed on the side that is of the bracket body and that faces the battery cell. The heat insulation plate, the bracket body, and the protruding structure enclose to form a cavity.

In a technical solution of this embodiment, the protruding structure is disposed on the side that is of the bracket body and that faces the battery cell. The heat insulation plate, the protruding structure, and the bracket body enclose to form the cavity, so that the cavity and the heat insulation plate jointly function to hinder heat transfer and provide a heat insulation effect, thereby reducing a negative impact of the high temperature generated by the battery cell on the electric control assembly.

In some embodiments, the protruding structure comprises a first reinforcing rib connected to the bracket body.

In the technical solution of this embodiment, the protruding structure comprises the first reinforcing rib, so that the first reinforcing rib can cooperate with the heat insulation plate and the bracket body to enclose to form a cavity to hinder heat transfer. In addition, the first reinforcing rib can also improve strength of the bracket.

In some embodiments, the protruding structure further comprises a second reinforcing rib connected to the bracket body, and the second reinforcing rib intersects the first reinforcing rib.

In the technical solution of this embodiment, the protruding structure further comprises the second reinforcing rib, and the second reinforcing rib intersects the first reinforcing rib, so that the first reinforcing rib and the second reinforcing rib can form a plurality of cavities, to better hinder heat transfer and improve the heat insulation effect. In addition, disposing the first reinforcing rib and the second reinforcing rib can also better improve the strength of the bracket.

In some embodiments, there are at least two first reinforcing ribs, and the first reinforcing ribs are spaced apart in a first direction. There are at least two second reinforcing ribs, and the second reinforcing ribs are spaced apart in a second direction. The second direction and the first direction are disposed with an included angle therebetween.

The technical solution of this embodiment provides some arrangement manners of the first reinforcing rib and the second reinforcing rib. This disposing can form a plurality of cavities on the side that is of the bracket body and that faces the battery cell, so as to better improve the heat insulation effect. In addition, this disposing can further improve the strength of the bracket.

In some embodiments, the first reinforcing rib and/or the second reinforcing rib can separate the cavity into at least two sub-cavities. A through hole is provided on the first reinforcing rib and/or the second reinforcing rib, to implement communication between the sub-cavities located on two sides of the through hole, and enable any one of the cavities to communicate with a space outside the electric control assembly.

In the technical solution of this embodiment, the through hole is provided on the first reinforcing rib and/or the second reinforcing rib, so that the cavities can communicate with each other. In this case, gas in the cavities can be exchanged with gas outside the cavities, and heat can be taken away during a gas exchange process, thereby better improving the heat insulation effect of the bracket.

In some embodiments, the ratio of the dimension of a corresponding through hole to the dimension of an adjacent cavity ranges from 0.25 to 0.4 in the length direction of the first reinforcing rib or the second reinforcing rib.

The technical solution of this embodiment provides some dimension ranges of the through hole, so that the through hole can not only allow gas to flow through to take away heat and achieve cooling through the flowing gas, but also reduce a negative impact of disposing of the through hole on strength of the first reinforcing rib and/or the second reinforcing rib.

In some embodiments, the electric control assembly further comprises a connecting structure. The connecting structure is disposed between the heat insulation plate and the bracket body, and the heat insulation plate is connected to the connecting structure. The heat insulation plate is connected to at least a part of the protruding structure, and/or, the heat insulation plate is spaced apart from at least a part of the protruding structure.

In the technical solution of this embodiment, the connecting structure is provided, so that the heat insulation plate is connected to the bracket body by means of the connecting structure, and the heat insulation plate can be better and more stably connected to the bracket body.

In some embodiments, the area of a part that is of the connecting structure and that is connected to the heat insulation plate is larger than the area of a side that is of the protruding structure and that faces the heat insulation plate.

In the technical solution of this embodiment, the area of the part that is of the connecting structure and that is connected to the heat insulation plate is larger than the area of the side that is of the protruding structure and that faces the heat insulation plate. Compared with a case where the heat insulation plate is directly connected to the protruding structure, this disposing can increase a connection area of the heat insulation plate, thereby improving stability of connection between the heat insulation plate and the bracket body.

In some embodiments, the dimension of the connecting structure is greater than the dimension of the protruding structure in an arrangement direction of the bracket body and the heat insulation plate.

The technical solution of this embodiment provides some dimensional relationships between the connecting structure and the protruding structure, so that the heat insulation plate can be spaced apart from the protruding structure when being connected to the connecting structure, thereby reducing interference of the protruding structure to connection between the heat insulation plate and the connecting structure, and enabling the heat insulation plate to be more stably connected to the connecting structure.

In some embodiments, the connecting structure comprises an abutment, and the abutment is connected to the bracket body. The connecting structure further comprises an adhesive layer. One side of the adhesive layer is connected to the abutment, and the other side of the adhesive layer is connected to the heat insulation plate.

In the technical solution of this embodiment, the connecting structure comprises the abutment and the adhesive layer to reduce the thickness of the adhesive layer. This not only reduces adhesive consumption, thereby enabling the heat insulation plate to be stably fixed to the bracket body, but also reduces costs.

In some embodiments, the dimension of the abutment is less than or equal to the dimension of the protruding structure in the arrangement direction of the bracket body and the heat insulation plate.

The technical solution of this embodiment provides some dimensional relationships between the abutment and the protruding structure, thereby defining the dimension of the adhesive layer. This disposing enables the abutment to provide a specific basis for the adhesive layer, so as to reduce the thickness of the adhesive layer, reduce adhesive consumption, and reduce costs. In addition, this disposing can also prevent the thickness of the adhesive layer from being excessively small, so that the adhesive layer can fix the heat insulation plate more stably.

In some embodiments, a difference between the dimension of the abutment and the dimension of the protruding structure ranges from 1 mm to 2 mm in the arrangement direction of the bracket body and the heat insulation plate.

The technical solution of this embodiment further provides some dimensional relationships between the abutment and the protruding structure, resulting in the proper thickness of the adhesive layer. In this case, the adhesive layer can stably fix the heat insulation plate, and the costs of the adhesive layer can be reduced.

In some embodiments, the connecting structure comprises the adhesive layer. One side of the adhesive layer is connected to the bracket body, and the other side of the adhesive layer is connected to the heat insulation plate.

In the technical solution of this embodiment, the connecting structure comprises the adhesive layer, so that the heat insulation plate is fixed to the bracket body by means of the adhesive layer.

In some embodiments, the dimension of the adhesive layer ranges from 1.2 mm to 2.2 mm in the arrangement direction of the bracket body and the heat insulation plate.

The technical solution of this embodiment provides some dimensional ranges of the adhesive layer, so that the adhesive layer can stably fix the heat insulation plate to the bracket body, and the costs of the adhesive layer can be reduced.

In some embodiments, a difference between the dimension of the connecting structure and the dimension of the protruding structure is less than or equal to 0.2 mm in the arrangement direction of the bracket body and the heat insulation plate.

The technical solution of this embodiment provides some dimensional relationships between the connecting structure and the protruding structure, so that the dimension of the connecting structure is greater than the dimension of the protruding structure. In this case, the heat insulation plate can be spaced apart from the protruding structure and is not in contact with the protruding structure, thereby reducing a negative impact of the protruding structure on connection stability of the heat insulation plate.

In some embodiments, there are at least two connecting structures.

In the technical solution of this embodiment, there are at least two connecting structures, to better fix the heat insulation plate to the bracket body.

In some embodiments, the connecting structure is located at an edge of the bracket body.

In the technical solution of this embodiment, the connecting structure is disposed at the edge of the bracket body to reduce warping of the heat insulation plate, thereby further improving the connection stability of the heat insulation plate.

In some embodiments, the dimension of the heat insulation plate ranges from 0.5 mm to 1 mm in the arrangement direction of the bracket body and the heat insulation plate.

The technical solution of this embodiment provides some dimensional ranges of the heat insulation plate, so that the heat insulation plate can cooperate with the cavity to better hinder heat transfer, and a space occupied by the heat insulation plate can be reduced.

In some embodiments, the electric control assembly further comprises a thermal conductive structure connected to the heat insulation plate. At least a part of the thermal conductive structure is accommodated in the cavity.

In the technical solution of this embodiment, the electric control assembly comprises the thermal conductive structure and the heat insulation plate. The heat insulation plate hinders heat transfer, and the thermal conductive structure transfers some heat on the heat insulation plate to air in the cavity, which facilitates heat dissipation through air circulation, thereby improving the heat insulation effect of the heat insulation plate.

In some embodiments, the thermal conductive structure is connected to the box body.

In the technical solution of this embodiment, the thermal conductive structure is connected to the box body, so that the thermal conductive structure can transfer some heat on the heat insulation plate to the box body, thereby achieving a better heat dissipation effect.

In some embodiments, the material of the bracket body comprises at least one of plastic, resin, or rubber.

The technical solution of this embodiment provides some specific structures of the bracket body. When a good heat insulation effect is achieved by the heat insulation plate and the cavity, this disposing can reduce the weight of the bracket body, so as to reduce the overall weight of the battery device.

In some embodiments, the electric control assembly further comprises an outer housing connected to the bracket body, and the electric control component is located in the outer housing. The outer housing and the bracket body are of an integrally injection-molded structure.

In the technical solution of this embodiment, the bracket body and the outer housing are of an integrally injection-molded structure, so that the structure can have relatively high stability, which can reduce problems such as uneven strength that may be caused by a process, e.g., secondary processing such as bonding and welding, and a risk that impurities outside the electric control assembly enter the outer housing can be reduced.

In some embodiments, the electric control assembly is disposed on a side that is of the battery cell and that is provided with a pressure relief structure.

The technical solution of this embodiment provides some mounting positions of the electric control assembly. When a good heat insulation effect is achieved by the heat insulation plate and the cavity, this disposing can reduce a demand of the electric control assembly on an internal space of the battery device.

According to a second aspect, an embodiment of the present application provides an energy storage device. The energy storage device includes the battery device provided in some embodiments according to the first aspect, and the battery device is used to store or provide electric energy.

According to a third aspect, an embodiment of the present application further provides an electric device. The electric device includes the battery device provided in some embodiments according to the first aspect or the energy storage device provided in some embodiments according to the second aspect, and the battery device is used to store or provide electric energy.

The above description is merely an overview of the technical solutions of the present application. For a clearer understanding of the technical means of the present application, the present application can be carried out in accordance with the content of the description, and in order to make the above and other objectives, characteristics, and advantages of the present application apparent and comprehensible, specific embodiments of the present application are described below.

### BRIEF DESCRIPTION OF THE DRAWINGS

To describe technical solutions in embodiments of the present application more clearly, the following briefly describes the accompanying drawings for describing the embodiments or the conventional technology. It is clear that the accompanying drawings described in the following are merely some embodiments of the present application. Those of ordinary skill in the art can still derive other accompanying drawings from these accompanying drawings without creative efforts.
FIG. 1 is a schematic structural diagram of a vehicle provided in some embodiments of the present application;
FIG. 2 is a schematic diagram of an exploded structure of a battery device provided in some embodiments of the present application;
FIG. 3 is a schematic diagram of an exploded structure of a battery cell according to some embodiments of the present application;
FIG. 4 is a schematic diagram of a bottom view of an electric control assembly according to some embodiments of the present application;
FIG. 5 is a schematic three-dimensional diagram of an electric control assembly with an electric control component removed according to some embodiments of the present application;
FIG. 6 is a schematic diagram of a top view of an electric control assembly with an electric control component removed according to some embodiments of the present application;
FIG. 7 is a schematic diagram of a bottom view of an electric control assembly with a heat insulation plate removed according to some embodiments of the present application;
FIG. 8 is a partially enlarged schematic diagram of F in FIG. 7;
FIG. 9 is a schematic sectional view of A-A line in FIG. 6;
FIG. 10 is a partially enlarged schematic diagram of E in FIG. 9 according to some embodiments of the present application;
FIG. 11 is a partially enlarged schematic diagram of E in FIG. 9 according to some other embodiments of the present application;
FIG. 12 is a schematic sectional view of B-B line in FIG. 6;
FIG. 13 is a schematic sectional view of C-C line in FIG. 7; and
FIG. 14 is a schematic sectional view of D-D line in FIG. 7.

Symbols in the figures have the following meanings:
1000-vehicle;
100-battery device;
10-box body; 11-first box body; 12-second box body;
20-battery cell; 21-housing; 22-end cap; 23-electrode assembly; 24-electrode terminal; 25-pressure relief structure;
30-electric control assembly 31-bracket; 311-bracket body; 312-protruding structure; 3121-first reinforcing rib; 3122-second reinforcing rib; 3123-through hole; 32-heat insulation plate; 33-cavity; 331-sub-cavity; 34-connecting structure; 341-abutment; 342-adhesive layer;
40-thermal conductive structure;
200-motor;
300-controller.

### DESCRIPTION OF EMBODIMENTS

Embodiments of the technical solutions of the present application are described in detail below with reference to the drawings. The following embodiments are only used to more clearly illustrate the technical solutions of the present application, and thus are used as examples only, and are not intended to limit the protection range of the present application.

Unless otherwise defined, all technical and scientific terms used in the present application have the same meanings as those commonly understood by persons skilled in the technical field of this application. The terms used in this specification are merely intended to describe specific embodiments, and are not intended to limit the present application. The terms "including", "having", and any variant thereof in the specification, the claims, and the foregoing accompanying drawings in the present application are intended to cover non-exclusive inclusion.

In the description of the embodiments of the present application, the technical terms "first", "second", and the like are used only for distinguishing between different objects, but cannot be construed to indicate or imply relative importance or implicitly indicate the number, specific order, or primary/secondary relationship of indicated technical features. In the description of the embodiments of the present application, "a plurality of" means two or more unless specifically defined otherwise.

Reference to "an embodiment" herein means that a particular feature, structure, or characteristic described with reference to the embodiment can be included in at least one embodiment of the present application. The phrase in various places in the description does not necessarily all refer to the same embodiment, or a separate or alternative embodiment mutually exclusive of other embodiments. It is explicitly and implicitly understood by a person skilled in the art that the embodiments described herein may be combined with other embodiments.

In the description of the embodiments of the present application, the term "and/or" merely describes an association relationship of associated objects, indicating that three relationships may exist, for example, A and/or B may mean that A exists alone, A and B exist simultaneously, or B exists alone. In addition, the character "/" herein generally indicates that associated objects are in a "or" relationship.

In the description of the embodiments of the present application, the term "a plurality of" means two or more (including two), and similarly, the term "a plurality of groups" means two or more groups (including two groups), and the term "a plurality of pieces" means two or more pieces (including two pieces).

In the description of the embodiments of the present application, an orientation or positional relationship indicated by technical terms "center", "longitudinal", "transverse", "length", "width", "thickness", "up", "down", "front", "back", "left", "right", "vertical", "horizontal", "top", "bottom", "inner", "outer", "clockwise", "counterclockwise", "axial", "radial", "circumferential", and the like is an orientation or positional relationship shown based on the accompanying drawings, is intended only to facilitate the description of the embodiments of the present application and simplification of the description rather than indicating or implying that an apparatus or an element indicated must have a specific orientation, or be constructed and operated in a specific orientation, and therefore is not intended to be construed as a limitation to the embodiments of the present application.

In the descriptions of the embodiment of the present application, unless otherwise explicitly specified and defined, the technical terms "mounted", "connected", "connect", "fixed", etc. are to be understood in a broad sense, for example, may be a fixed connection, a detachable connection, or an integrated connection; may be a mechanical connection or an electrical connection; may be a direct connection or an indirect connection implemented through an intermediate medium; or may be an internal communication between two elements or an interaction relationship between two elements. A person of ordinary skill in the art may understand the specific meanings of the above terms in the embodiments of the present application according to specific situations.

At present, in view of the development of the market, the use of power batteries is becoming increasingly more widespread. Power batteries are used not only in energy storage power systems such as hydropower, thermal power, wind power, and solar power plants, but also in electric tools such as electric bicycles, electric motorcycles, and electric vehicles, as well as military equipment, aerospace, and many other fields. As an application field of power batteries continues to expand, a market demand for power batteries continues to increase.

In addition to a battery cell, a battery device is usually further provided with an electric control assembly or another electric control assembly, to implement monitoring, control, protection, and the like of the battery cell. For example, a battery management system is usually disposed in the battery device, and the battery management system is mainly used to monitor a state of the battery device.

The battery cell tends to generate a relatively high temperature during a charging and discharging process. In a case of thermal runaway of the battery cell, the temperature generated by the battery cell tends to further increase. However, due to the limitation of an internal space of a box body of the battery device, a distance between each electric control assembly and the battery cell is usually small. Based on this, a temperature of each electric control assembly is prone to rise during use of the battery cell, which may easily cause damage such as a short-circuit to an electric control component such as a circuit board and a connection terminal inside the electric control assembly.

Based on the above considerations, in order to alleviate a problem that the high temperature generated by the battery cell easily causes damage to the electric control assembly, embodiments of the present application provide a battery device, so that the electric control assembly includes a bracket and an electric control component. The electric control component is disposed on a side that is of a bracket body and that is away from the battery cell, and a heat insulation plate is disposed on a side that is of the bracket body and that faces the battery cell. A protruding structure is disposed on the side that is of the bracket body and that faces the battery cell, so that the bracket body, the protruding structure, and the heat insulation plate enclose to form a cavity.

In such a battery device, the heat insulation plate can hinder heat transfer, thereby reducing possible damage caused by heat to the circuit board or another electric control component. In addition, the cavity can further hinder heat transfer and dissipate heat away from the electric control assembly, to further reduce the possible damage caused by heat to the circuit board or another electric control component.

The battery device disclosed in the embodiments of the present application can be used in an electric device using a battery as a power supply or various energy storage systems using a battery as an energy storage component. The electric device can be, but is not limited to, a mobile phone, a tablet computer, a notebook computer, an electric toy, an electric tool, a battery-powered vehicle, an electric vehicle, a ship, a spacecraft, and the like. The electric toy may include a stationary or mobile electric toy, such as a game machine, an electric car toy, an electric ship toy, an electric airplane toy, and the like, and the spacecraft may be an airplane, a rocket, a space shuttle, a spaceship, etc.

To facilitate description, in the following embodiments, as an example for description, an electric device in an embodiment of the present application is a vehicle 1000.

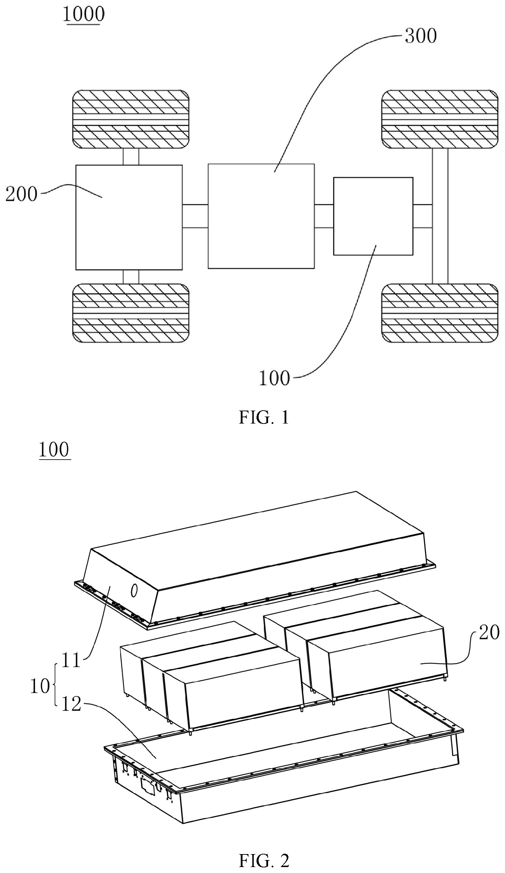

Referring to FIG. 1, FIG. 1 is a schematic diagram of a structure of a vehicle 1000 according to some embodiments of the present application. The vehicle 1000 may be a fuel vehicle, a gas vehicle, or a new energy vehicle, and the new energy vehicle may be a battery electric vehicle, a hybrid vehicle, or a range-extended electric vehicle. Inside the vehicle 1000, a battery apparatus 100 is provided, which may be provided at the bottom, head, or tail of the vehicle 1000. The battery device 100 may be used to power the vehicle 1000. For example, the battery device 100 may be used as an operating power supply of the vehicle 1000. The vehicle 1000 may further include a controller 300 and a motor 200. The controller 300 is used to control the battery device 100 to power the motor 200, e.g., for a working power requirement of the vehicle 1000 during starting, navigating, and driving.

In some embodiments of the present application, the battery device 100 may be used not only as the operating power source of the vehicle 1000, but also as a driving power source of the vehicle 1000, instead of or partially instead of fuel or natural gas to provide driving power for the vehicle 1000.

Referring to FIG. 2, FIG. 2 is a schematic diagram of an exploded structure of a battery device 100 according to some embodiments of the present application.

The battery device 100 mentioned in this embodiment of the present application may include one or more battery assemblies for providing voltage and capacity. The battery assembly may include a plurality of battery cells 20. The plurality of battery cells 20 are connected in series, in parallel, or in series-parallel by means of a bus component.

In some embodiments, the battery assembly is usually formed by arranging the plurality of battery cells 20.

As an example, the battery assembly may be a battery module, and the battery module is an independent module formed by arranging and fixing the plurality of battery cells 20. As an example, the battery module may be formed by bundling the plurality of battery cells 20 by means of a cable tie.

In some embodiments, the battery assembly may be a battery pack. The battery pack includes a box body 10 and one or more battery assemblies, and the battery assemblies are accommodated in the box body 10.

As an example, the battery assembly may be a battery module, and the battery assembly may be accommodated in the box body 10 by means of fixing the battery module in the box body 10.

As an example, the battery assembly may alternatively be accommodated in the box body 10 by means of directly fixing the plurality of battery cells 20 in the box body 10.

As an example, the box body 10 may include a first box body 11 and a second box body 12. The first box body 11 is snap-fitted with the second box body 12, so that a closed space is formed inside the box body 10 to accommodate the battery assembly. The term "closed" herein means covered or closed, which may be sealed or unsealed. The first box body 11 may be a cap or a bottom plate.

As an example, the box body 10 may include a cap, a framework, and a bottom plate. Each of the cap and the bottom plate is connected to the framework, so that the closed space is formed inside the box body 10 to accommodate the battery assembly.

In some embodiments, the box body 10 may be used as a part of a chassis structure of the vehicle 1000. For example, a part of the box body 10 may be at least a part of a floor of the vehicle 1000, or a part of the box body 10 may be at least a part of a cross beam and a longitudinal beam of the vehicle 1000.

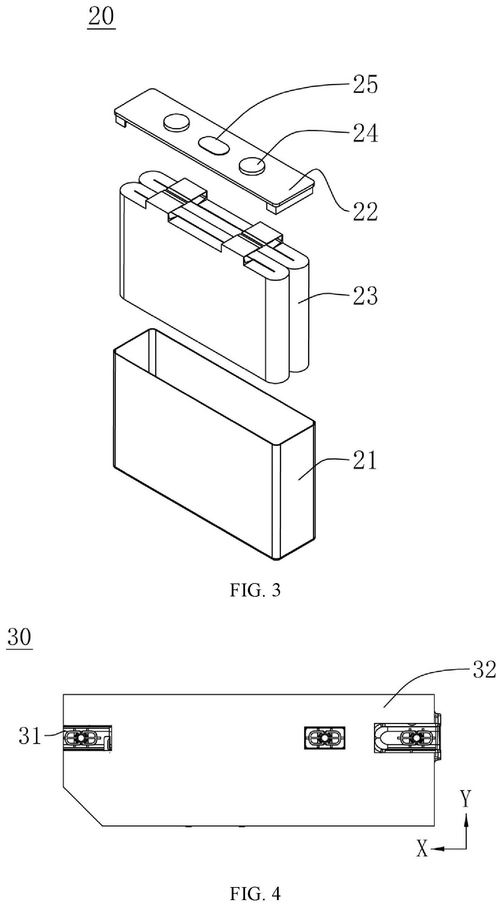

Referring to FIG. 3, FIG. 3 is a schematic diagram of an exploded structure of a battery cell 20 according to some embodiments of the present application. The battery cell 20 is a minimum unit constituting the battery device 100. As shown in the figure, the battery cell 20 includes an end cap 22, a housing 21, an electrode assembly 23, and another functional component.

The end cap 22 is a component that covers the opening of the casing body 21 to isolate the internal environment of the battery cell 20 from the external environment. Without limitation, the shape of the end cap 22 may adapt to the shape of the casing body 21 to fit the casing body 21. Optionally, the end cap 22 may be made of a material with specific hardness and strength (e.g., aluminum alloy). As such, the end cap 22 is less prone to deformation under compressive impact, thereby enabling the battery cell 20 to have higher structural strength and improved safety performance. The end cap 22 may be provided with a functional component such as an electrode terminal 24. The electrode terminal 24 may be configured to be electrically connected to the electrode assembly 23 for outputting electric energy from or inputting electric energy into the battery cell 20. In some embodiments, a pressure relief structure 25 for relieving internal pressure may be further disposed on the end cap 22 when the internal pressure or a temperature of the battery cell 20 reaches a threshold. The end cap 22 may be made of various materials, such as copper, iron, aluminum, stainless steel, aluminum alloy, and plastic. This is not limited in this embodiment of the present application. In some embodiments, an insulation member may be further disposed on an inner side of the end cap 22, and the insulation member may be used to isolate an electrical connection component in the housing 21 from the end cap 22 to reduce a risk of a short-circuit. For example, the insulation member may be plastic, rubber, etc.

The housing 21 is an assembly for cooperating with the end cap 22 to form the internal environment of the battery cell 20, where the formed internal environment may be used to accommodate the electrode assembly 23, an electrolyte solution, and another component. The housing 21 and the end cap 22 may be separate members. An opening may be provided on the housing 21, and the inner environment of the battery cell 20 may be formed by closing the end cap 22 at the opening. Without limitation, the end cap 22 and the housing 21 may also be integrated. Specifically, the end cap 22 and the housing 21 may form a joint connection surface before another component is fitted into the housing, and then the end cap 22 is enabled to cover the housing 21 when an interior of the housing 21 needs to be enclosed. The housing 21 may be in various shapes and various dimensions, such as a cuboid, a cylinder, or a hexagonal prism. Specifically, a shape of the housing 21 may be determined based on a specific shape and dimension of the electrode assembly 23. The housing 21 may be made of various materials, such as copper, iron, aluminum, stainless steel, aluminum alloy, and plastic. This is not specially limited in this embodiment of the present application.

The electrode assembly 23 is a component in the battery cell 20 in which an electrochemical reaction occurs. The housing 21 may include one or more electrode assemblies 23. The electrode assembly 23 is mainly formed by winding or stacking a positive electrode plate and a negative electrode plate, and a separator is usually disposed between the positive electrode plate and the negative electrode plate. Parts that are of the positive electrode plate and the negative electrode plate and that have an active material constitute a main body portion of the electrode assembly 23, and a part that is of each of the positive electrode plate and the negative electrode plate and that does not have an active material constitutes a tab. A positive tab and a negative tab may both be located at one end of the main body portion or be located at two ends of the main body portion respectively. During a charging and discharging process of the battery cell 20, a positive electrode active material and a negative electrode active material react with the electrolyte solution, and the tab is connected to the electrode terminal 24 to form a current circuit.

Referring to FIG. 4 to FIG. 7, according to a first aspect, some embodiments of the present application provide a battery device 100, including a box body 10, a battery cell 20, and an electric control assembly 30. The battery cell 20 is accommodated in the box body 10. The electric control assembly 30 is accommodated in the box body 10. The electric control assembly 30 includes a bracket 31 and an electric control component, and the bracket 31 includes a bracket body 311. A side that is of the bracket body 311 and that faces the battery cell 20 is connected to a protruding structure 312, and a side that is of the bracket body 311 and that is away from the battery cell 20 is provided with the electric control component. The electric control assembly 30 further includes a heat insulation plate 32 disposed on the side that is of the bracket body 311 and that faces the battery cell 20. The heat insulation plate 32, the bracket body 311, and the protruding structure 312 enclose to form a cavity 33.

In the figure, a direction of an X axis is the length direction of the electric control assembly 30, a direction of a Y axis is a width direction of the electric control assembly 30, and a direction of a Z axis is a height direction of the electric control assembly 30.

The box body 10 is configured to provide an accommodating space for the battery cell 20 and the electric control assembly 30. The box body 10 may be cylindrical, cuboid, or in another shape. The accommodating space may be provided in the box body 10 to accommodate the battery cell 20, the electric control assembly 30, etc.

The battery cell 20 is a minimum unit constituting the battery device 100. The battery cell 20 may be a secondary battery, and the secondary battery is a battery cell 20 that may be continuously used by activating an active material by charging the battery cell 20 after discharging thereof. The battery cell 20 may be a lithium ion battery, a sodium ion battery, a sodium-lithium ion battery, a lithium metal battery, a sodium metal battery, a lithium-sulfur battery, a magnesium ion battery, a nickel-hydrogen battery, a nickel-cadmium battery, a lead-acid battery, etc. This is not limited in this embodiment of the present application.

The electric control assembly 30 is a power-consuming component in the battery device 100 and is configured to control a state of the battery device 100 or collect information. The electric control assembly 30 may include a battery management system (BMS) or a cell supervisory circuit (CSC). When the electric control assembly 30 includes a battery pipeline system, the electric control assembly 30 may be directly connected to each battery cell 20 and monitor state information, e.g., a voltage and a temperature of each battery cell 20, to ensure effective management of a battery, optimize a charging process through data analysis, prolong a service life of the battery, and prevent potential dangers such as overcharging, overdischarging, a short-circuit, and overheating. In addition, the electric control assembly 30 may further have a balancing function, which may balance a charge level of each battery unit, thereby avoiding overall performance degradation caused by imbalance between cells.

The electric control assembly 30 is accommodated in the box body 10. The electric control assembly 30 may be connected to the battery cell 20, may be connected to the box body 10, or may be connected to another structure of the battery device 100. For example, the electric control assembly 30 may be connected to the battery cell 20, to reduce a space between the battery cell 20 and the electric control assembly 30, thereby reducing a space occupied by the electric control assembly 30, and reducing a negative impact of the electric control assembly 30 on an energy density of the battery device 100.

The bracket 31 is a structure in the electric control assembly 30 mainly for providing a fixation basis for a structure such as the electric control component. Based on a mounting position of the electric control assembly 30, the bracket 31 may be connected to the battery cell 20, or may be connected to the box body 10 or another structure of the battery device 100. The material of the bracket 31 may include metal, plastic, or another material.

It can be understood that the electric control assembly 30 may further include another structure. For example, the electric control assembly 30 may further include a lid body connected to the bracket 31 to form a space for accommodating a structure such as the electric control component, so that the structure such as the electric control component can be separated from a space outside the electric control assembly 30.

The bracket body 311 is a main structure of the bracket 31, and the electric control component may be disposed on the bracket body 311. The bracket body 311 may be a plate-shaped structure, a block-shaped structure, or a structure of another shape, and the bracket body 311 may be rectangular, circular, or in another shape. The material of the bracket body 311 may include metal, plastic, or another material.

The electric control component is a circuit electronic structure in the electric control assembly 30. The electric control component may include a circuit board, an electronic component, or another electrical structure. The circuit board is a support that connects the electronic component to a circuit together, and is configured to implement functions such as circuit layout design and electrical signal transmission.

The electric control component is disposed on the side that is of the bracket body 311 and that is away from the battery cell 20. In this case, the bracket body 311 can block some heat, to reduce heat transferred to the electric control component, thereby improving stability of the electric control assembly 30 and reducing damage caused by a temperature outside the electric control assembly 30 to the electric control assembly 30. The electric control component may be connected to the bracket body 311 through welding or screwing, or in another manner.

The protruding structure 312 is a structure protruding from the bracket body 311. The protruding structure 312 may include a structure such as a rib, a flange, a plate, a platform, or a column. The protruding structure 312 may alternatively be a platform-shaped structure or a structure of another shape. A shape of the protruding structure 312 may include a rectangle, a triangle, or another shape. The protruding structure 312 may include only a same structure, or may include a plurality of different structures. The protruding structure 312 is connected to the bracket body 311. The protruding structure 312 may be connected to the bracket body 311 through welding, bonding, or screwing, or in another manner, and the protruding structure 312 may alternatively be integrally formed with the bracket body 311.

The heat insulation plate 32 is a structure in the electric control assembly 30 for hindering heat transfer. The heat insulation plate 32 has poor thermally conductive performance, thereby hindering heat transfer. A shape of the heat insulation plate 32 may be circular, square, trapezoid, or another shape, and the shape of the heat insulation plate 32 may alternatively be set based on the shape of the bracket body 311. The material of the heat insulation plate 32 may include mica, asbestos, or another material with good heat insulation performance.

The heat insulation plate 32 is disposed on the side that is of the bracket body 311 and that faces the battery cell 20, to prevent heat generated by the battery cell 20 from being transferred to the electric control component. The heat insulation plate 32 may be directly connected to the bracket body 311, for example, the heat insulation plate 32 may be connected to the bracket body 311 through welding or screwing, or in another manner. The heat insulation plate 32 may alternatively be indirectly connected to the bracket body 311, for example, the heat insulation plate 32 may be connected to the bracket body 311 by means of an intermediate structural member. When the protruding structure 312 is disposed on the side that is of the bracket body 311 and that faces the battery cell 20, the heat insulation plate 32 may also be connected to the protruding structure 312.

The protruding structure 312 is disposed on the side that is of the bracket body 311 and that faces the battery cell 20, and the heat insulation plate 32 is spaced apart from the bracket body 311 under action of the protruding structure 312. In this case, the heat insulation plate 32, the bracket body 311, and the protruding structure 312 jointly enclose to form a cavity 33. The cavity 33 is formed between the heat insulation plate 32 and the bracket body 311 and is located on the side that is of the bracket body 311 and that faces the battery cell 20. The cavity 33 may be a space in a rectangular shape, a cylinder shape, or another shape. Based on shapes of the protruding structure 312, the heat insulation plate 32, and the bracket body 311, the cavity 33 may be a closed space, and the cavity 33 may alternatively be an open space communicating with an environment outside the electric control assembly 30. Based on shapes and a quantity of protruding structures 312, there may be one cavity 33, or may be two or more cavities 33.

When the cavity 33 is a closed space, air in the cavity 33 can play a role of hindering heat transfer due to poor thermally conductive performance of air. When the cavity 33 is an open space, the air in the cavity 33 can flow and exchange with air outside the cavity 33, and can exchange heat with the environment outside the electric control assembly 30 to achieve an effect of heat dissipation, thereby better achieving an effect of hindering heat transfer.

The protruding structure 312 is mainly used to separate the heat insulation plate 32 from the bracket body 311, so as to form the cavity 33 between the heat insulation plate 32 and the bracket body 311, and improve a heat insulation effect through the air in the cavity 33. In this case, a space occupied by the protruding structure 312 needs to be relatively small, so that the cavity 33 has a larger space and can better achieve the heat insulation effect.

As an ambient temperature increases, stability of the electric control component decreases, and the electric control component is also prone to deformation. For example, when the electric control component is a circuit board, the circuit board is subject to solder joint detachment, loosening or detachment of an electronic component, etc., at a high temperature, which may easily lead to a malfunction or damage of the electric control assembly 30.

Based on this, in this embodiment, the protruding structure 312 is disposed on the side that is of the bracket body 311 and that faces the battery cell 20, and the cavity 33 is enclosed by means of the heat insulation plate 32, the protruding structure 312, and the bracket body 311. The cavity 33 functions together with the heat insulation plate 32 to hinder heat transfer and achieve the heat insulation effect, thereby reducing a negative influence of the high temperature generated by the battery cell 20 on the electric control assembly 30.

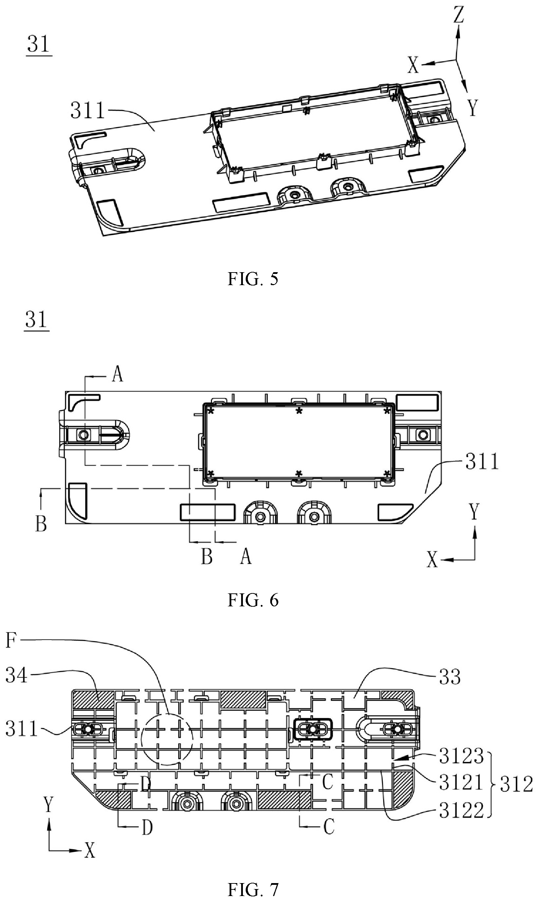

Referring to FIG. 7, in some embodiments, the protruding structure 312 includes a first reinforcing rib 3121 connected to the bracket body 311.

The first reinforcing rib 3121 is a partial structure of the protruding structure 312, and the first reinforcing rib 3121 can improve the strength of the bracket body 311. The first reinforcing rib 3121 may be in a shape of a rectangular plate, a triangular plate, or a prism, or may be a structure of another shape. There may be one first reinforcing rib 3121, or may be two or more first reinforcing ribs 3121.

The heat insulation plate 32 may be connected to a side that is of the first reinforcing rib 3121 and that is away from the bracket body 311. Alternatively, the heat insulation plate 32 may be directly connected to the bracket body 311 or connected to the bracket body 311 by means of another intermediate structure.

The heat insulation plate 32 and the bracket body 311 may enclose to form a cavity 33 together with the first reinforcing rib 3121. Based on a quantity and shapes of first reinforcing ribs 3121, the cavity 33 may be an open space or a closed space, and there may be one cavity 33, or may be two or more cavities 33.

For example, when there is one first reinforcing rib 3121, the cavity 33 enclosed by the heat insulation plate 32, the bracket body 311, and the first reinforcing rib 3121 may be an open space, and one or more sides of the cavity 33 can communicate with the environment outside the electric control assembly 30, to facilitate air circulation and implement heat dissipation.

For example, when there are two or more first reinforcing ribs 3121, extension directions of the first reinforcing ribs 3121 may be different and intersect. In this case, the first reinforcing ribs 3121, the heat insulation plate 32, and the bracket body 311 can enclose a closed cavity 33, to hinder heat transfer through air in the cavity 33.

In this embodiment, the protruding structure 312 includes the first reinforcing rib 3121, so that the first reinforcing rib 3121 can cooperate with the heat insulation plate 32 and the bracket body 311 to enclose to form the cavity 33 to hinder heat transfer. In addition, the first reinforcing rib 3121 can also improve the strength of the bracket 31.

Referring to FIG. 7, in some embodiments, the protruding structure 312 further includes a second reinforcing rib 3122 connected to the bracket body 311, and the second reinforcing rib 3122 intersects the first reinforcing rib 3121.

The second reinforcing rib 3122 is a partial structure of the protruding structure 312, and the second reinforcing rib 3122 can improve the strength of the bracket body 311. The second reinforcing rib 3122 may be in a shape of a rectangular plate, a triangular plate, or a prism, or may be a structure of another shape. There may be one second reinforcing rib 3122, or may be two or more second reinforcing ribs 3122.

The heat insulation plate 32 may be connected to a side that is of the second reinforcing rib 3122 and that is away from the bracket body 311. Alternatively, the heat insulation plate 32 may be directly connected to the bracket body 311 or connected to the bracket body 311 by means of another intermediate structure.

The second reinforcing rib 3122 intersects the first reinforcing rib 3121. In other words, the length direction of the second reinforcing rib 3122 is different from that of the first reinforcing rib 3121. The heat insulation plate 32 and the bracket body 311 may enclose to form a cavity 33 together with the first reinforcing rib 3121 and the second reinforcing rib 3122. Based on quantities and shapes of first reinforcing ribs 3121 and second reinforcing ribs 3122, the cavity 33 may be an open space or a closed space, and there may be one cavity 33, or may be two or more cavities 33.

For example, when there is one first reinforcing rib 3121 and one second reinforcing rib 3122, a cavity 33 enclosed by the heat insulation plate 32, the bracket body 311, the first reinforcing rib 3121, and the second reinforcing rib 3122 may be an open space. One or more sides of the cavity 33 can communicate with the environment outside the electric control assembly 30, to facilitate air circulation and implement heat dissipation.

For example, when there are two or more first reinforcing ribs 3121 and two or more second reinforcing rib 3122, two second reinforcing ribs 3122, two first reinforcing ribs 3121, the heat insulation plate 32, and the bracket body 311 can enclose a closed cavity 33. The cavity 33 is located between the two second reinforcing ribs 3122, between the two first reinforcing ribs 3121, and between the bracket body 311 and the heat insulation plate 32. The air in the closed cavity 33 can hinder heat transfer.

In this embodiment, the protruding structure 312 further includes the second reinforcing rib 3122, and the second reinforcing rib 3122 intersects the first reinforcing rib 3121, so that the first reinforcing rib 3121 and the second reinforcing rib 3122 can form a plurality of cavities 33, to better hinder heat transfer and improve the heat insulation effect. In addition, disposing the first reinforcing rib 3121 and the second reinforcing rib 3122 can also better improve the strength of the bracket 31.

Referring to FIG. 7, in some embodiments, there are at least two first reinforcing ribs 3121, and the first reinforcing ribs 3121 are spaced apart in a first direction. There are at least two second reinforcing ribs 3122, and the second reinforcing ribs 3122 are spaced apart in a second direction. The second direction and the first direction are disposed with an included angle therebetween.

There are at least two first reinforcing ribs 3121. In other words, there may be two first reinforcing ribs 3121, or may be three or more first reinforcing ribs 3121. The first reinforcing ribs 3121 are arranged in the first direction. The first direction may be a length direction X of the electric control assembly 30, may be a width direction Y of the electric control assembly 30, or may be another direction. The first reinforcing ribs 3121 are spaced apart in the first direction, so that there is a space between every two adjacent first reinforcing ribs 3121.

When the first reinforcing ribs 3121 are arranged in the first direction, the length direction of the first reinforcing ribs 3121 may be perpendicular to the first direction, or may intersect the first direction at an angle.

There are at least two second reinforcing ribs 3122. In other words, there may be two second reinforcing ribs 3122, or may be three or more second reinforcing ribs 3122. The second reinforcing ribs 3122 are arranged in the second direction. The second direction may be the width direction Y of the electric control assembly 30, may be the length direction X of the electric control assembly 30, or may be another direction. The second reinforcing ribs 3122 are spaced apart in the second direction, so that there is a space between every two adjacent second reinforcing ribs 3122.

When the second reinforcing ribs 3122 are arranged in the second direction, the length direction of the second reinforcing ribs 3122 may be perpendicular to the second direction, or may intersect the second direction at an angle.

The first reinforcing rib 3121 intersects the second reinforcing rib 3122. In this case, when there are a plurality of first reinforcing ribs 3121 and a plurality of second reinforcing ribs 3122, two first reinforcing ribs 3121 and two second reinforcing ribs 3122 can cooperate with the bracket body 311 and the heat insulation plate 32 to enclose a closed cavity 33, so as to hinder heat transfer by means of the air in the cavity 33, thereby achieving the effect of heat insulation.

For example, the first direction is the length direction X of the electric control assembly 30, and the second direction is the width direction Y of the electric control assembly 30. The length direction of the first reinforcing rib 3121 is parallel to the width direction Y of the electric control assembly 30, and the length direction of the second reinforcing rib 3122 is parallel to the length direction X of the electric control assembly 30. In this case, the first reinforcing rib 3121 and the second reinforcing rib 3122 can separate into a plurality of rectangular spaces on the bracket body 311. In this case, each of the rectangular spaces can form a closed cavity 33 under action of the bracket body 311 and the heat insulation plate 32.

There are at least two first reinforcing ribs 3121 and two second reinforcing ribs 3122, and the first reinforcing ribs 3121 intersect the second reinforcing ribs 3122 to improve the strength of the bracket body 311, so that the bracket body 311 can better provide support and protection for a structure such as an electric control component.

When strength required by the bracket body 311 is specified, due to the presence of the first reinforcing rib 3121 and the second reinforcing rib 3122, the bracket body 311 may be made of more materials. For example, because the first reinforcing rib 3121 and the second reinforcing rib 3122 can improve the strength of the bracket body 311, the bracket body 311 may be made of a material with relatively low strength yet relatively low weight, e.g., plastic, to reduce the weight of the electric control assembly 30.

This embodiment provides some arrangement manners of the first reinforcing rib 3121 and the second reinforcing rib 3122. This disposing can form a plurality of cavities 33 on the side that is of the bracket body 311 and that faces the battery cell 20, so as to better improve the heat insulation effect. In addition, this disposing can further improve the strength of the bracket 31.

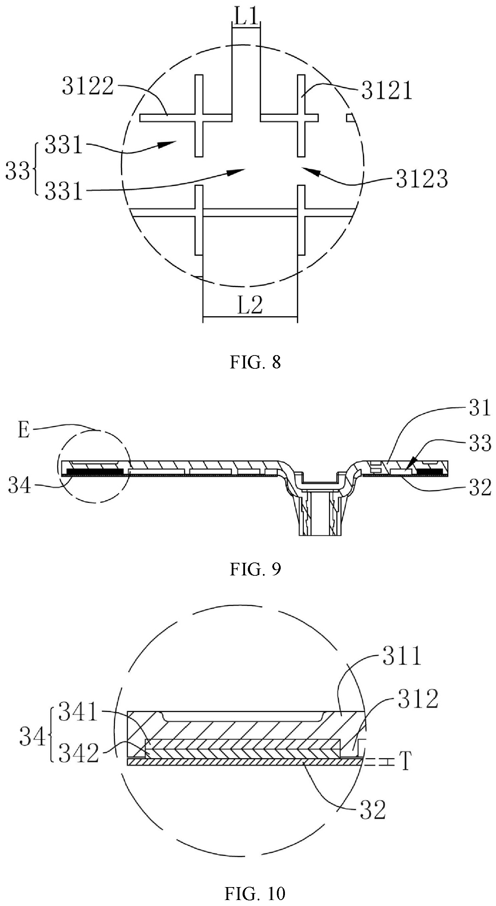

Referring to FIG. 7 and FIG. 8, in some embodiments, the first reinforcing rib 3121 and/or the second reinforcing rib 3122 can separate the cavity 33 into at least two sub-cavities 331. A through hole 3123 is provided on the first reinforcing rib 3121 and/or the second reinforcing rib 3122, to implement communication between the sub-cavities 331 on two sides of the through hole 3123, and enable any one of the sub-cavities 331 to communicate with the space outside the electric control assembly 30.

When the protruding structure 312 includes the first reinforcing rib 3121 and the second reinforcing rib 3122, the first reinforcing rib 3121 and the second reinforcing rib 3122 can separate the cavity 33 into a plurality of sub-cavities 331. In other words, the sub-cavity 331 is a spatial structure formed by separating the cavity 33 by means of the first reinforcing rib 3121 and/or the second reinforcing rib 3122.

There may be two, three, or more sub-cavities 331. Each of the sub-cavities 331 may be a cuboid-shaped spatial structure, a cylindrical spatial structure, a prism-shaped spatial structure, or a spatial structure of another shape. A quantity, shapes, and arrangement manners of sub-cavities 331 also vary based on quantities and arrangement manners of first reinforcing ribs 3121 and second reinforcing ribs 3122. For example, the sub-cavities 331 may be cuboid-shaped spaces, and are arranged in an array in the length direction X and the width direction Y of the electric control assembly 30.

The through hole 3123 is a hole structure provided on the first reinforcing rib 3121 or the second reinforcing rib 3122. The through hole 3123 may be a circular hole, a square hole, or a hole structure of another shape. Alternatively, the through hole 3123 may be a straight hole, a stepped hole, a tapered hole, or a structure of the through hole 3123 of another shape. The through hole 3123 may partition and separate a corresponding first reinforcing rib 3121 or a corresponding second reinforcing rib 3122 into two parts. Alternatively, the through hole 3123 may be provided only on a part of the first reinforcing rib 3121 or a part of the second reinforcing rib 3122. The through hole 3123 may be provided only on the first reinforcing rib 3121 or the second reinforcing rib 3122, or through holes 3123 may be provided on both the first reinforcing rib 3121 and the second reinforcing rib 3122. One first reinforcing rib 3121 or one second reinforcing rib 3122 may be provided with only one through hole 3123, or two or more through holes 3123.

The through hole 3123 is configured to implement communication between the sub-cavities 331 on two sides of the through hole 3123, and the through hole 3123 is also configured to communicate a sub-cavity 331 on one side of a corresponding first reinforcing rib 3121 or a corresponding second reinforcing rib 3122 with the space outside the electric control assembly 30. In addition, this disposing enables any one of the cavities 33 to communicate with the space outside the electric control assembly 30, and each of the cavities 33 may directly communicate with the space outside the electric control assembly 30, or may indirectly communicate with the space outside the electric control assembly 30 by means of another cavity 33.

When there are a plurality of first reinforcing ribs 3121 and a plurality of second reinforcing ribs 3122, there may be a plurality of sub-cavities 331 on one side of one first reinforcing rib 3121. In this case, the first reinforcing rib 3121 may be provided with a plurality of through holes 3123, and each of the through holes 3123 can communicate with each of the sub-cavities 331. Similar to the first reinforcing rib 3121, there may also be a plurality of sub-cavities 331 on one side of one second reinforcing rib 3122. In this case, the second reinforcing rib 3122 may be provided with a plurality of through holes 3123, and each of the through holes 3123 can communicate with each of the sub-cavities 331.

It can be understood that, when any sub-cavity 331 can directly or indirectly communicate with the space outside the electric control assembly 30, the sub-cavity 331 may communicate with all other adjacent sub-cavities 331, or the sub-cavity 331 may communicate with only one or several adjacent sub-cavities 331.

Because each sub-cavity 331 can communicate with the space outside the electric control assembly 30, air outside the electric control assembly 30 can enter each sub-cavity 331, and air in each sub-cavity 331 can be discharged to the space outside the electric control assembly 30. In other words, the air in each sub-cavity 331 can circulate and exchange with the air outside the electric control assembly 30 to achieve the effect of heat dissipation. In this case, the air in each sub-cavity 331 can hinder heat transferred to the bracket body 311, and circulating air can also play a role of heat dissipation, so that possible damage caused by a high temperature to a structure such as an electric control component can be better reduced.

In this embodiment, the through hole 3123 is provided on the first reinforcing rib 3121 and/or the second reinforcing rib 3122, so that the sub-cavities 331 can communicate with each other. In this case, gas in the sub-cavities 331 can exchange with gas outside the cavities 33, and heat can be taken away during a gas exchange process, thereby better improving the heat insulation effect of the bracket 31.

Referring to FIG. 7 and FIG. 8, in some embodiments, the ratio of the dimension of a corresponding through hole 3123 to the dimension of an adjacent cavity 33 ranges from 0.25 to 0.4 in the length direction of the first reinforcing rib 3121 or the second reinforcing rib 3122.

Because the through hole 3123 is provided on the first reinforcing rib 3121 or the second reinforcing rib 3122, the dimension of the through hole 3123 in the length direction of a corresponding first reinforcing rib 3121 or a corresponding second reinforcing rib 3122 is one radial dimension of the through hole 3123, that is, a dimension denoted by L1 in FIG. 8.

The dimension of the cavity 33 in the length direction of the first reinforcing rib 3121 or the second reinforcing rib 3122 corresponds to a dimension, in a radial direction of the through hole 3123, of a part that is of the corresponding first reinforcing rib 3121 or the corresponding second reinforcing rib 3122 and that corresponds to the corresponding cavity 33. The dimension is a dimension denoted by L2 in FIG. 8.

A larger dimension of the through hole 3123 on the first reinforcing rib 3121 or the second reinforcing rib 3122 indicates a higher circulation efficiency of air in cavities 33 that are located at two sides of the through hole 3123 and that communicate with each other. However, a larger dimension of the through hole 3123 on the first reinforcing rib 3121 or the second reinforcing rib 3122 indicates lower strength of the corresponding first reinforcing rib 3121 or the corresponding second reinforcing rib 3122.

The ratio of the dimension of the through hole 3123 to the dimension of the adjacent cavity 33 ranges from 0.25 to 0.4, that is, the ratio of L1 to L2 ranges from 0.25 to 0.4. For example, the ratio may be 0.25, 0.3, 0.35, 0.4, or another value.

For example, the ratio of the dimension of the through hole 3123 to the dimension of the adjacent cavity 33 may be 0.25. In this case, the dimension of the through hole 3123 in the radial direction thereof is relatively small, and strength of the corresponding first reinforcing rib 3121 or the corresponding second reinforcing rib 3122 is relatively high.

For example, the ratio of the dimension of the through hole 3123 to the dimension of the adjacent cavity 33 may be 0.32. In this case, the dimension of the through hole 3123 in the radial direction thereof is moderate, so that the air can flow through the through hole 3123 with relatively high efficiency, and the strength of the corresponding first reinforcing rib 3121 or the corresponding second reinforcing rib 3122 is also moderate.

For example, the ratio of the dimension of the through hole 3123 to the dimension of the adjacent cavity 33 may be 0.4. In this case, the dimension of the through hole 3123 in the radial direction thereof is relatively large, so that the air can flow through the through hole 3123 with higher efficiency to better dissipate heat and hinder heat transfer.

This embodiment provides some dimension ranges of the through hole 3123, so that the through hole 3123 can not only allow gas to flow through to take away heat and achieve cooling through the flowing gas, but also reduce a negative impact of disposing of the through hole 3123 on the strength of the first reinforcing rib 3121 and/or the second reinforcing rib 3122.

Referring to FIG. 6, FIG. 7, and FIG. 9 to FIG. 12, in some embodiments, the electric control assembly 30 further includes a connecting structure 34. The connecting structure 34 is disposed between the heat insulation plate 32 and the bracket body 311, and the heat insulation plate 32 is connected to the connecting structure 34. The heat insulation plate 32 is connected to at least a part of the protruding structure 312, and/or, the heat insulation plate 32 is spaced apart from at least a part of the protruding structure 312.

The connecting structure 34 is a structure in the electric control assembly 30 for connecting the heat insulation plate 32 to the bracket body 311, and the connecting structure 34 is located between the heat insulation plate 32 and the bracket body 311. In other words, the connecting structure 34 is disposed on the side that is of the bracket body 311 and that faces the battery cell 20, to fix the heat insulation plate 32 to the side that is of the bracket body 311 and that faces the battery cell 20. There may be one connecting structure 34, or may be two or more connecting structures 34.

The connecting structure 34 may include a clamping structure, such as a snap. The connecting structure 34 may also include a screwing structure, such as a bolt and a nut. The connecting structure 34 may also include an adhesive structure, such as a layered structure formed by means of structural adhesive. It can be understood that the connecting structure 34 may also include another structure, which is not limited to the above structures.

Based on a specific structure of the connecting structure 34, the connecting structure 34 may be connected to the heat insulation plate 32 through screwing, bonding, or clamping, or in another manner. Based on the specific structure of the connecting structure 34, the connecting structure 34 may be connected to the bracket body 311 through screwing, bonding, or clamping, or in another manner, or the connecting structure 34 may alternatively be integrally formed with the bracket body 311.

When the heat insulation plate 32 is connected to the bracket body 311 by means of the connecting structure 34, the heat insulation plate 32 may also be connected to at least a part of the protruding structure 312, so that the heat insulation plate 32 can be more stably fixed to the bracket body 311. When the heat insulation plate 32 is connected to at least a part of the protruding structure 312, the heat insulation plate 32 may be connected to only the part of the protruding structure 312, or may be connected to the entire protruding structure 312. For example, when the protruding structure 312 includes a plurality of first reinforcing ribs 3121 and a plurality of second reinforcing ribs 3122, and the heat insulation plate 32 is connected to the connecting structure 34, the heat insulation plate 32 may be further connected to the first reinforcing ribs 3121 and the second reinforcing ribs 3122. In this case, the heat insulation plate 32 and the bracket body 311 can cooperate with the plurality of first reinforcing ribs 3121 and the plurality of second reinforcing ribs 3122 to form a plurality of cavities 33. It is difficult for the cavities 33 to communicate with each other at connection points between the heat insulation plate 32 and the first reinforcing ribs 3121, and to communicate with each other at connection points between the heat insulation plate 32 and the second reinforcing ribs 3122.

When the heat insulation plate 32 is connected to the bracket body 311 by means of the connecting structure 34, the heat insulation plate 32 may also be spaced apart from at least a part of the protruding structure 312 to reduce possible interference caused by the protruding structure 312 to connection between the heat insulation plate 32 and the connecting structure 34, so that the heat insulation plate 32 can more stably be connected to the connecting structure 34. When the heat insulation plate 32 is spaced apart from at least a part of the protruding structure 312, the heat insulation plate 32 may be spaced apart from only the part of the protruding structure 312, or may be spaced apart from the entire protruding structure 312. For example, when the protruding structure 312 includes a plurality of first reinforcing ribs 3121 and a plurality of second reinforcing ribs 3122, the heat insulation plate 32 is spaced apart from the first reinforcing ribs 3121 and the second reinforcing ribs 3122. In this case, the heat insulation plate 32 and the bracket body 311 can cooperate with the plurality of first reinforcing ribs 3121 and the plurality of second reinforcing ribs 3122 to form a plurality of cavities 33. The cavities 33 can communicate with each other at a position at which the heat insulation plate 32 is close to the first reinforcing ribs 3121, and can also communicate with each other at a position at which the heat insulation plate 32 is close to the second reinforcing ribs 3122. It can be understood that a distance between the heat insulation plate 32 and the protruding structure 312 should not be excessively large, so as to reduce the space occupied by the electric control assembly 30.

In this embodiment, the connecting structure 34 is provided, so that the heat insulation plate 32 is connected to the bracket body 311 by means of the connecting structure 34, and the heat insulation plate 32 can be better and more stably connected to the bracket body 311.

Referring to FIG. 7, in some embodiments, the area of a part that is of the connecting structure 34 and that is connected to the heat insulation plate 32 is larger than the area of a side that is of the protruding structure 312 and that faces the heat insulation plate 32.

The area of the part that is of the connecting structure 34 and that is connected to the heat insulation plate 32 can reflect stability of the connection between the heat insulation plate 32 and the connecting structure 34. A larger area of the part that is of the connecting structure 34 and that is connected to the heat insulation plate 32 indicates stronger stability of the connection between the heat insulation plate 32 and the connecting structure 34. When there are a plurality of connecting structures 34, the area of the part that is of the connecting structure 34 and that is connected to the heat insulation plate 32 is a sum of areas of parts that are of connecting structures 34 and that are connected to the heat insulation plate 32.

The area of the side that is of the protruding structure 312 and that faces the heat insulation plate 32 is the area of a side of each of all protruding structures 312 and that faces the heat insulation plate 32. When the protruding structure 312 includes a plurality of first reinforcing ribs 3121 and a plurality of second reinforcing ribs 3122, the area of the side that is of the protruding structure 312 and that faces the heat insulation plate 32 is a sum of areas of sides that are of the first reinforcing ribs 3121 and the second reinforcing ribs 3122 and that face the heat insulation plate 32.

The protruding structure 312 is mainly used to separate the heat insulation plate 32 from the bracket body 311 to form a space between the heat insulation plate 32 and the bracket body 311, and improve the heat insulation effect through the air in the cavities 33. As such, a space occupied by the protruding structure 312 should be relatively small, and the area of a part available on the protruding structure 312 for connection with the heat insulation plate 32 should be relatively small, which easily causes poor connection stability of the heat insulation plate 32.

Based on this, in this embodiment, the area of the part that is of the connecting structure 34 and that is connected to the heat insulation plate 32 is larger than the area of the side that is of the protruding structure 312 and that faces the heat insulation plate 32. Compared with a case where the heat insulation plate 32 is directly connected to the protruding structure 312, this disposing can increase a connection area of the heat insulation plate 32, thereby improving stability of connection between the heat insulation plate 32 and the bracket body 311.

Referring to FIG. 5 to FIG. 7, and FIG. 9 to FIG. 14, in some embodiments, the dimension of the connecting structure 34 is greater than the dimension of the protruding structure 312 in an arrangement direction of the bracket body 311 and the heat insulation plate 32.

The arrangement direction of the bracket body 311 and the heat insulation plate 32 may be the direction of the Z axis in FIG. 5. The dimension of the connecting structure 34 in the arrangement direction is greater than the dimension of the protruding structure 312, that is, an end that is of the connecting structure 34 and that is away from the bracket body 311 is higher than an end that is of the protruding structure 312 and that is away from the bracket body 311.

Because the heat insulation plate 32 is connected to the end that is of the connecting structure 34 and that is away from the bracket body 311, after the heat insulation plate 32 is connected to the connecting structure 34, this disposing can create a gap between the heat insulation plate 32 and the protruding structure 312, so as to reduce the possible interference caused by the protruding structure 312 to stable connection between the heat insulation plate 32 and the connecting structure 34, thereby enabling the heat insulation plate 32 to be more stably connected to the connecting structure 34.

This embodiment provides some dimensional relationships between the connecting structure 34 and the protruding structure 312, so that the heat insulation plate 32 can be spaced apart from the protruding structure 312 when being connected to the connecting structure 34, thereby reducing the interference of the protruding structure 312 to the connection between the heat insulation plate 32 and the connecting structure 34, and enabling the heat insulation plate 32 to be more stably connected to the connecting structure 34.

Referring to FIG. 6, FIG. 7, and FIG. 9 to FIG. 14, in some embodiments, the connecting structure 34 includes an abutment 341, and the abutment 341 is connected to the bracket body 311. The connecting structure 34 further includes an adhesive layer 342. One side of the adhesive layer 342 is connected to the abutment 341, and the other side of the adhesive layer 342 is connected to the heat insulation plate 32.

The abutment 341 is a part that is of the connecting structure 34 and that is connected to the bracket body 311, and the abutment 341 is configured to provide a fixation basis for the adhesive layer 342. The abutment 341 may be a cuboid-shaped structure, a cylindrical structure, a truncated cone shaped structure, a prism-shaped structure, or a structure of another shape. The abutment 341 may be connected to the bracket body 311 through screwing, clamping, or bonding, or in another manner, and the abutment 341 may alternatively be integrally formed with the bracket body 311. The material of the abutment 341 may include metal, plastic, foam, or another material, and the material of the abutment 341 may be the same as or different from the material of the bracket body 311.

For example, the abutment 341 is formed by the bracket body 311 protruding toward the heat insulation plate 32, that is, the abutment 341 and the bracket body 311 are integrally formed. In this case, the abutment 341 may be formed by stamping the bracket body 311.

The adhesive layer 342 is a part that is of the connecting structure 34 and that is connected to the heat insulation plate 32. The adhesive layer 342 is used to bond the heat insulation plate 32 to the abutment 341, thereby fixing the heat insulation plate 32 to the bracket body 311. The adhesive layer 342 may completely cover the abutment 341, or may cover only a part of the abutment 341. The area of the part that is of the connecting structure 34 and that is connected to the heat insulation plate 32 is the area of a part that is of the adhesive layer 342 and that is connected to the heat insulation plate 32.

When the connecting structure 34 only includes the abutment 341 and the adhesive layer 342, the dimension of the connecting structure 34 in the arrangement direction of the bracket body 311 and the heat insulation plate 32 is a sum of the dimension of the abutment 341 in the arrangement direction and the dimension of the adhesive layer 342 in the arrangement direction.

Because the protruding structure 312 has a specific dimension in the arrangement direction of the bracket body 311 and the heat insulation plate 32, the connecting structure 34 includes the abutment 341, so as to reduce the thickness of the adhesive layer 342 and shorten duration required for forming the adhesive layer 342, thereby improving fixation efficiency of the heat insulation plate 32, and reducing costs of the adhesive layer 342. In addition, because strength of the adhesive layer 342 is usually weaker than strength of a structural member such as the bracket body 311, excessive thickness of the adhesive layer 342 easily reduces the connection stability of the heat insulation plate 32, and causes the heat insulation plate 32 to wobble relative to the bracket body 311. In this case, the connecting structure 34 includes a base layer, and the connecting structure 34 can also improve the connection stability of the heat insulation plate 32.

In this embodiment, the connecting structure 34 includes the abutment 341 and the adhesive layer 342 to reduce the thickness of the adhesive layer 342. This not only reduces adhesive consumption, thereby enabling the heat insulation plate 32 to be stably fixed to the bracket body 311, but also reduces costs.

Referring to FIG. 6 to FIG. 7, and FIG. 9 to FIG. 14, in some embodiments, the dimension of the abutment 341 is less than or equal to the dimension of the protruding structure 312 in the arrangement direction of the bracket body 311 and the heat insulation plate 32.

The dimension of the abutment 341 in the arrangement direction of the bracket body 311 and the heat insulation plate 32 is the dimension of a part that is of the abutment 341 and that protrudes from the bracket body 311, that is, the height of the bracket body 311. The dimension of the protruding structure 312 in the arrangement direction of the bracket body 311 and the heat insulation plate 32 is the dimension of a part that is of the protruding structure 312 and that protrudes from the bracket body 311, that is, the height of the protruding structure 312.

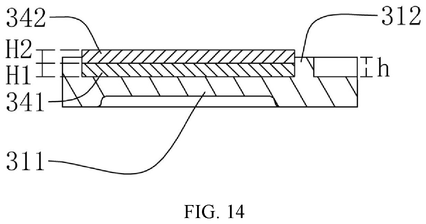

Referring to FIG. 14, when the bracket body 311 and the heat insulation plate 32 are arranged in the height direction Z of the electric control assembly 30, a dimension denoted by H1 is the dimension of the abutment 341 in the arrangement direction of the bracket body 311 and the heat insulation plate 32, and a dimension denoted by h is the dimension of the protruding structure 312 in the arrangement direction of the bracket body 311 and the heat insulation plate 32.

The height of the abutment 341 is less than the height of the protruding structure 312, that is, H1<h. In this case, the protruding structure 312 can cooperate with the abutment 341 to form a space with an opening at one end to accommodate at least a part of the adhesive layer 342. In other words, a part that is of the adhesive layer 342 and that is connected to the abutment 341 can be located in the space, so that a shape of the adhesive layer 342 is limited by the protruding structure 312, and displacement of the adhesive layer 342 in a direction of a side portion of the adhesive layer 342 can be limited, thereby improving stability of the adhesive layer 342.

For example, the adhesive layer 342 is formed by solidification of liquid adhesive. In this case, the protruding structure 312 can cooperate with the abutment 341 to form a space for accommodating the liquid adhesive, so as to facilitate injection of the liquid adhesive into the space.

It can be understood that, when the dimension of the connecting structure 34 in the arrangement direction of the bracket body 311 and the heat insulation plate 32 is determined, this disposing can also indirectly define the dimension of the adhesive layer 342 in the arrangement direction of the bracket body 311 and the heat insulation plate 32.

This embodiment provides some dimensional relationships between the abutment 341 and the protruding structure 312, thereby defining the dimension of the adhesive layer 342. This disposing can enable the abutment 341 to provide a specific basis for the adhesive layer 342, so as to reduce the thickness of the adhesive layer 342, reduce adhesive consumption, and reduce costs. In addition, this disposing can also prevent the thickness of the adhesive layer 342 from being excessively small, so that the adhesive layer 342 can fix the heat insulation plate 32 more stably.

Referring to FIG. 6, FIG. 7, and FIG. 9 to FIG. 14, in some embodiments, a difference between the dimension of the abutment 341 and the dimension of the protruding structure 312 ranges from 1 mm to 2 mm in the arrangement direction of the bracket body 311 and the heat insulation plate 32.

The dimension of the abutment 341 in the arrangement direction of the bracket body 311 and the heat insulation plate 32 is the height of the part that is of the abutment 341 and that protrudes from the bracket body 311, that is, a dimension denoted by H1 in FIG. 14. The dimension of the protruding structure 312 in the arrangement direction of the bracket body 311 and the heat insulation plate 32 is the height of the part that is of the protruding structure 312 and that protrudes from the bracket body 311, that is, the dimension denoted by h in FIG. 14. Because the height of the abutment 341 is less than the height of the protruding structure 312, a difference between the height of the abutment 341 and the height of the protruding structure 312 is the height of a part that is of the protruding structure 312 and that is higher than the abutment 341.

The difference between the height of the abutment 341 and the height of the protruding structure 312 can reflect the thickness of the adhesive layer 342. A smaller difference indicates smaller thickness of the adhesive layer 342, and a smaller amount of adhesive applied for the adhesive layer 342.

The difference between the height of the abutment 341 and the height of the protruding structure 312 may be 1 mm, 1.1. mm, 1.2 mm, 1.3 mm, 1.4 mm, 1.5 mm, 1.6 mm, 1.7 mm, 1.8 mm, 1.9 mm, 2 mm, or another parameter.

For example, the difference between the height of the abutment 341 and the height of the protruding structure 312 may be 1 mm. In this case, the height of the abutment 341 is relatively large, and overall strength of the connecting structure 34 is also relatively high. The thickness of the adhesive layer 342 can be relatively small, an amount of adhesive applied for the adhesive layer 342 is also relatively small, and the costs of the adhesive layer 342 are relatively low.

For example, the difference between the height of the abutment 341 and the height of the protruding structure 312 may be 1.5 mm. In this case, the height of the abutment 341 is moderate, the thickness of the adhesive layer 342 is also moderate, so that the heat insulation plate 32 can be stably connected to the abutment 341 by means of the adhesive layer 342, and the costs of the adhesive layer 342 can also be reduced.

For example, the difference between the height of the abutment 341 and the height of the protruding structure 312 may be 2 mm. In this case, the thickness of the adhesive layer 342 is relatively large, and the heat insulation plate 32 can be more stably connected to the abutment 341 by means of the adhesive layer 342, so that the heat insulation plate 32 can be more stably connected to the bracket body 311.

This embodiment further provides some dimensional relationships between the abutment 341 and the protruding structure 312, so that the adhesive layer 342 can stably fix the heat insulation plate 32, the costs of the adhesive layer 342 can be reduced, and the strength of the connecting structure 34 can be relatively high.

Referring to FIG. 6, FIG. 7, and FIG. 9 to FIG. 14, in some embodiments, the connecting structure 34 includes the adhesive layer 342. One side of the adhesive layer 342 is connected to the bracket body 311, and the other side of the adhesive layer 342 is connected to the heat insulation plate 32.

In this embodiment, the connecting structure 34 includes the adhesive layer 342 and does not include the abutment 341, and the heat insulation plate 32 may be directly connected to the bracket body 311 by means of the adhesive layer 342. In this case, the dimension of the connecting structure 34 in the arrangement direction of the bracket body 311 and the heat insulation plate 32 is the dimension of the adhesive layer 342. When the dimension of the connecting structure 34 in the arrangement direction is greater than the dimension of the protruding structure 312, the dimension of the adhesive layer 342 in the direction is greater than the dimension of the protruding structure 312.

In this embodiment, the connecting structure 34 includes the adhesive layer 342, so that the heat insulation plate 32 is fixed to the bracket body 311 by means of the adhesive layer 342.

Referring to FIG. 6, FIG. 7, and FIG. 9 to FIG. 14, in some embodiments, the dimension of the adhesive layer 342 ranges from 1.2 mm to 2.2 mm in the arrangement direction of the bracket body 311 and the heat insulation plate 32.

The dimension of the adhesive layer 342 in the arrangement direction of the bracket body 311 and the heat insulation plate 32 is the thickness of the adhesive layer 342, that is, a dimension denoted by H2 in FIG. 14. The thickness of the adhesive layer 342 is related to the connection stability of the heat insulation plate 32. Larger thickness of the adhesive layer 342 indicates a larger amount of adhesive applied for the adhesive layer 342, and higher stability of connection between the heat insulation plate 32 and the adhesive layer 342; however, the costs are higher accordingly.

The thickness of the adhesive layer 342 may be 1.2 mm, 1.3 mm, 1.4 mm, 1.5 mm, 1.6 mm, 1.7 mm, 1.8 mm, 1.9 mm, 2 mm, 2.1 mm, 2.2 mm, or another parameter.

For example, the thickness of the adhesive layer 342 may be 1.2 mm. In this case, the thickness of the adhesive layer 342 can be relatively small, the amount of adhesive applied for the adhesive layer 342 is also relatively small, and the costs of the adhesive layer 342 are relatively low.

For example, the thickness of the adhesive layer 342 may be 1.7 mm. In this case, the thickness of the adhesive layer 342 is moderate, the heat insulation plate 32 can be stably connected to the adhesive layer 342, and the costs of the adhesive layer 342 can also be reduced.

For example, the thickness of the adhesive layer 342 may be 2.2 mm. In this case, the thickness of the adhesive layer 342 is relatively large, and the heat insulation plate 32 can be more stably connected to the adhesive layer 342, so that the heat insulation plate 32 can be more stably connected to the bracket body 311.

This embodiment provides some dimensional ranges of the adhesive layer 342, so that the adhesive layer 342 can stably fix the heat insulation plate 32 to the bracket body 311, and the costs of the adhesive layer 342 can be reduced.

Referring to FIG. 6, FIG. 7, and FIG. 9 to FIG. 14, in some embodiments, a difference between the dimension of the connecting structure 34 and the dimension of the protruding structure 312 is less than or equal to 0.2 mm in the arrangement direction of the bracket body 311 and the heat insulation plate 32.

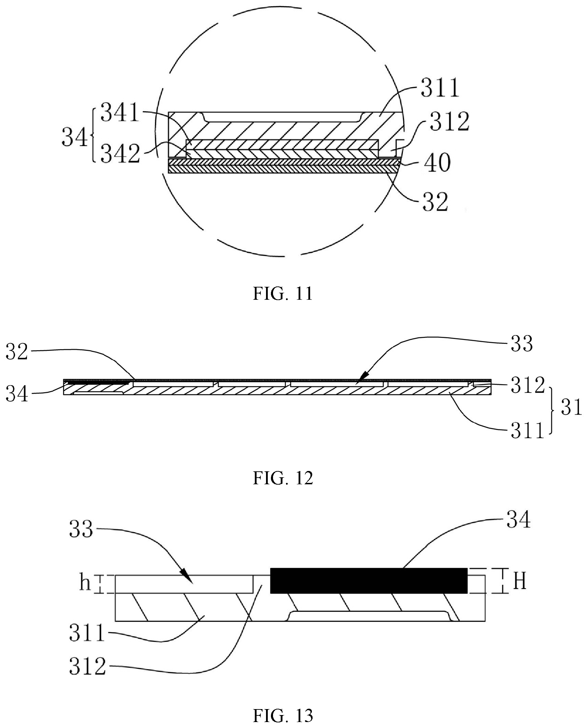

The dimension of the connecting structure 34 in the arrangement direction of the bracket body 311 and the heat insulation plate 32 is the height of a part that is of the connecting structure 34 and that protrudes from the bracket body 311, that is, a dimension denoted by H in FIG. 13. The dimension of the protruding structure 312 in the arrangement direction of the bracket body 311 and the heat insulation plate 32 is the height of the part that is of the protruding structure 312 and that protrudes from the bracket body 311, that is, a dimension denoted by h in FIG. 13. Because the height of the connecting structure 34 is greater than or equal to the height of the protruding structure 312, the difference between the height of the connecting structure 34 and the height of the protruding structure 312 is the height of a part that is of the connecting structure 34 and that is higher than the protruding structure 312.

The difference between the height of the connecting structure 34 and the height of the protruding structure 312 is less than or equal to 0.2 mm. To be specific, the difference between the height of the connecting structure 34 and the height of the protruding structure 312 may be 0.2 mm, or may be 0.15 mm, 0.1 mm, 0.05 mm, or another parameter.

For example, the difference between the height of the connecting structure 34 and the height of the protruding structure 312 may be 0.2 mm, to reduce possible interference caused by the protruding structure 312 to the connection between the heat insulation plate 32 and the connecting structure 34. This also prevents a distance between the heat insulation plate 32 and the protruding structure 312 from being excessively large, thereby reducing the space occupied by the electric control assembly 30.

This embodiment provides some dimensional relationships between the connecting structure 34 and the protruding structure 312, so that the dimension of the connecting structure 34 is greater than the dimension of the protruding structure 312. In this case, the heat insulation plate 32 can be spaced apart from the protruding structure 312 and is not in contact with the protruding structure 312, thereby reducing a negative impact of the protruding structure 312 on the connection stability of the heat insulation plate 32.

Referring to FIG. 7, in some embodiments, there are at least two connecting structures 34.

There may be two connecting structures 34, or may be three or more connecting structures 34. The connecting structures 34 may be connected to different positions on the heat insulation plate 32 and connected to different positions on the bracket body 311, so as to better fix the heat insulation plate 32 to the bracket body 311.

For example, the connecting structures 34 are evenly arranged around the side that is of the bracket body 311 and that faces the heat insulation plate 32, and the connecting structures 34 are symmetrically arranged, so that the connecting structures 34 can more stably fix the heat insulation plate 32 to the bracket body 311.

In this embodiment, there are at least two connecting structures 34, to better fix the heat insulation plate 32 to the bracket body 311.

Referring to FIG. 7, in some embodiments, the connecting structure 34 is located at an edge of the bracket body 311.

Because the connecting structure 34 is disposed on the side that is of the bracket body 311 and that faces the battery cell 20, the connecting structure 34 is located on an edge of the side that is of the bracket body 311 and that faces the battery cell 20. The connecting structure 34 may be located on any edge of the side that is of the bracket body 311 and that faces the battery cell 20, or may be located at two adjacent edges of the side that is of the bracket body 311 and that faces the battery cell 20. In other words, the connecting structure 34 may also be located at a corner of the side that is of the bracket body 311 and that faces the battery cell 20.

When there are a plurality of connecting structures 34, the connecting structures 34 may be spaced apart evenly at edges of the side that is of the bracket body 311 and that faces the battery cell 20, to reduce a case such as warping of the heat insulation plate 32, thereby more stably fixing the heat insulation plate 32 to the bracket body 311.

In this embodiment, the connecting structure 34 is disposed at the edge of the bracket body 311 to reduce warping of the heat insulation plate 32, thereby further improving the connection stability of the heat insulation plate 32.

Referring to FIG. 6, FIG. 9, and FIG. 10, in some embodiments, the dimension of the heat insulation plate 32 ranges from 0.5 mm to 1 mm in the arrangement direction of the bracket body 311 and the heat insulation plate 32.

The dimension of the heat insulation plate 32 in the arrangement direction of the bracket body 311 and the heat insulation plate 32 is the thickness of the heat insulation plate 32, that is, a dimension denoted by T in FIG. 10. The thickness of the heat insulation plate 32 may be 0.5 mm, 0.6 mm, 0.7 mm, 0.8 mm, 0.9 mm, 1 mm, or another value.

The thickness of the heat insulation plate 32 can reflect heat insulation performance of the heat insulation plate 32. When the material of the heat insulation plate 32 is determined, larger thickness of the heat insulation plate 32 indicates better heat insulation performance of the heat insulation plate 32, but a space occupied by the heat insulation plate 32 is correspondingly larger.

For example, the thickness of the heat insulation plate 32 may be 0.5 mm. In this case, the thickness of the heat insulation plate 32 is relatively small, resulting in a relatively small space occupied by the heat insulation plate 32, relatively small weight of the heat insulation plate 32, and relatively low costs.

For example, the thickness of the heat insulation plate 32 may be 0.75 mm. In this case, the thickness of the heat insulation plate 32 is moderate, so that the heat insulation plate 32 has good heat insulation performance and the occupied space is not excessively large.

For example, the thickness of the heat insulation plate 32 may be 1 mm. In this case, the thickness of the heat insulation plate 32 is relatively large, and the heat insulation performance of the heat insulation plate 32 is better. In addition, the heat insulation plate 32 can also play a role of assisting in reinforcing the strength of the bracket body 311, and can better protect a structure such as an electric control component.

This embodiment provides some dimensional ranges of the heat insulation plate 32, so that the heat insulation plate 32 can cooperate with a cavity 33 to better hinder heat transfer, and the space occupied by the heat insulation plate 32 can be reduced.

Referring to FIG. 6, FIG. 9, and FIG. 11, in some embodiments, the electric control assembly 30 further includes a thermal conductive structure 40 connected to the heat insulation plate 32. At least a part of the thermal conductive structure 40 is accommodated in a cavity 33.

The thermal conductive structure 40 is a structure mainly used for heat conduction in the electric control assembly 30, and the thermal conductive structure 40 can mainly dissipate heat on the heat insulation plate 32 to the air in the cavity 33, so as to reduce the heat transferred to a structure such as an electric control component by means of the bracket body 311. The thermal conductive structure 40 may include an independent structural member, such as a plate-shaped structure, or the thermal conductive structure 40 may include a layered structure formed on the heat insulation plate 32, such as a coating layer. In addition, the thermal conductive structure 40 may include another structure. The thermal conductive structure 40 may be a rectangular structure, a circular structure, or a structure of another shape, and a shape of the thermal conductive structure 40 may alternatively be set based on shapes of the heat insulation plate 32 and the bracket body 311. The material of the thermal conductive structure 40 may include silicon, graphene, or another material with good thermally conductive performance.

At least a part of the thermal conductive structure 40 is accommodated in the cavity 33, and the thermal conductive structure 40 may be completely accommodated in the cavity 33. When the cavity 33 is separated into the plurality of sub-cavities 331 by the first reinforcing ribs 3121 and/or the second reinforcing ribs 3122, there may be a plurality of thermal conductive structures 40, and each of the thermal conductive structures 40 is accommodated in each of the sub-cavities 331.

Only one part of the thermal conductive structure 40 may alternatively be accommodated in the cavity 33. In this case, the other part of the thermal conductive structure 40 may be opposite to the protruding structure 312, or the other part of the thermal conductive structure 40 may also extend outside the bracket body 311. For example, the thermal conductive structure 40 may be a complete continuous structure. One part of the thermal conductive structure 40 is opposite to the cavity 33 or each sub-cavity 331, the other part of the thermal conductive structure 40 is opposite to the protruding structure 312, and a remaining part of the thermal conductive structure 40 can extend outside the bracket body 311.

Because at least a part of the thermal conductive structure 40 is accommodated in the cavity 33, and the cavity 33 is formed between the bracket body 311 and the heat insulation plate 32, that is, the thermal conductive structure 40 is located on a side that is of the heat insulation plate 32 and that faces the bracket body 311, so that heat on the thermal conductive structure 40 can be dissipated to the air in the cavity 33. The heat insulation plate 32 is located on a side that is of the thermal conductive structure 40 and that is away from the bracket body 311, to hinder heat transfer and reduce heat transferred to the thermal conductive structure 40. When the heat insulation plate 32 is connected to the connecting structure 34, the thermal conductive structure 40 may be connected to the connecting structure 34, and the thermal conductive structure 40 may also be connected to the heat insulation plate 32.

In this embodiment, the electric control assembly 30 includes the thermal conductive structure 40 and the heat insulation plate 32. The heat insulation plate 32 hinders heat transfer, and the thermal conductive structure 40 transfers some heat on the heat insulation plate 32 to the air in the cavity 33, which facilitates heat dissipation through air circulation, thereby improving the heat insulation effect of the heat insulation plate 32.

Referring to FIG. 6, FIG. 9, and FIG. 11, in some embodiments, the thermal conductive structure 40 is connected to the box body 10.

Only one side of the thermal conductive structure 40 may be connected to the box body 10, or a plurality of sides of the thermal conductive structure 40 may be connected to the box body 10. Because a side that is of the thermal conductive structure 40 and that faces the bracket body 311 may be connected to the bracket body 311, and a side that is of the thermal conductive structure 40 and that is away from the bracket body 311 is connected to the heat insulation plate 32, a side portion of the thermal conductive structure 40 may be connected to the box body 10. The thermal conductive structure 40 may abut against the box body 10, or may be connected to the box body 10 through bonding or welding, or in another manner. The thermal conductive structure 40 may be directly connected to the box body 10, or may be indirectly connected to the box body 10 by means of an intermediate structural member. The thermal conductive structure 40 may be connected to an inner wall surface of the box body 10, such as an inner wall of the cap of the box body 10 or an inner wall of the bottom plate of the box body 10. Alternatively, the thermal conductive structure 40 may be connected to a beam structure inside the box body 10, such as an expansion beam or a frame beam.

The thermal conductive structure 40 is connected to the box body 10, so that some heat on the thermal conductive structure 40 can be transferred to the box body 10, thereby further reducing the heat transferred to the bracket body 311 and transferred to the structure such as the electric control component through the bracket body 311, and improving the heat insulation effect.

In this embodiment, the thermal conductive structure 40 is connected to the box body 10, so that the thermal conductive structure 40 can transfer some heat on the heat insulation plate 32 to the box body 10, to better play a role of heat dissipation.

In some embodiments, the material of the bracket body 311 includes at least one of plastic, resin, or rubber.

The material of the bracket body 311 may include only any one of plastic, resin, or rubber, or may include any two or more of plastic, resin, or rubber. Plastic, resin, and rubber each have advantages of being lightweight, easy to process, and low in costs.

The protruding structure 312 is disposed on the bracket body 311, and the protruding structure 312 can play a role of improving the strength of the bracket body 311. In this case, when the strength required by the bracket body 311 remains unchanged, the material of the bracket body 311 may be a material with relatively low strength. The bracket body 311 is provided with the heat insulation plate 32 and the cavity 33, the bracket body 311 has good heat insulation effect. In this case, when a heat insulation requirement of the bracket body 311 remains unchanged, the material of the bracket body 311 may be a material with poor heat insulation performance.

Based on this, this embodiment provides some materials of the bracket body 311. When the heat insulation plate 32 cooperates with the cavity 33 to perform good heat insulation effect, and the protruding structure 312 improves the strength of the bracket body 311, this disposing can reduce the weight of the bracket body 311, so as to reduce the overall weight of the battery device 100, and reduce the costs of the bracket body 311.

In some embodiments, the electric control assembly 30 further includes an outer housing connected to the bracket body 311, and the electric control component is located in the outer housing. The outer housing and the bracket body 311 are of an integrally injection-molded structure.

The outer housing is a structure used to cooperate with the bracket body 311 to form the internal environment of the electric control assembly 30. The structure such as the electric control component may be accommodated in the outer housing, so that the outer housing separates the structure such as the electric control component from the space outside the electric control assembly 30, thereby protecting the structure such as the electric control component. The outer housing and the bracket body 311 may form a closed internal environment, or the outer housing and the bracket body 311 may form an open external environment communicating with the space outside the electric control assembly 30. The outer housing may be square, circular, or in another shape.

The outer housing and the bracket body 311 are of an integrally injection-molded structure. In other words, the outer housing and the bracket body 311 are formed by an integrally injection-molding process, so as to improve consistency between the outer housing and the bracket body 311, and further improve stability of the structure. In addition, this disposing can also improve strength of the structure and improve processing efficiency.

In this embodiment, the bracket body 311 and the outer housing are of an integrally injection-molded structure, so that the structure can have relatively high stability, which can reduce problems such as uneven strength that may be caused by a process, e.g., secondary processing such as bonding and welding, and a risk that impurities outside the electric control assembly 30 enter the outer housing can be reduced.

In some embodiments, the electric control assembly 30 is disposed on a side that is of the battery cell 20 and that is provided with a pressure relief structure 25.

The pressure relief structure 25 in the battery cell 20 is used to relieve internal pressure when the internal pressure or a temperature reaches a standard. The pressure relief structure 25 may include an explosion-proof valve, an explosion-proof film, or another structure. The pressure relief structure 25 may be disposed on the end cap 22 of the battery cell 20, or may be disposed on the housing 21 of the battery cell 20. One battery cell 20 may be disposed with one pressure relief structure 25, or may be disposed with two or more pressure relief structures 25.

The side that is of the battery cell 20 and that is provided with the pressure relief structure 25 is usually provided with a specific space for gas discharge. In this case, the electric control assembly 30 is disposed on the side that is of the battery cell 20 and that is provided with the pressure relief structure 25, so that space utilization can be improved and the negative influence of the electric control assembly 30 on the energy density of the battery device 100 can be reduced. In addition, in a case of thermal runaway of the battery cell 20, under the protection of the heat insulation plate 32 and the cavity 33, a high-temperature flue gas caused by thermal runaway is not easy to damage the electric control component in the electric control assembly 30.

This embodiment provides some mounting positions of the electric control assembly 30. When a good heat insulation effect is achieved by the heat insulation plate 32 and the cavity 33, this disposing can reduce a demand of the electric control assembly 30 on an internal space of the battery device 100.

In some embodiments, the battery device 100 includes the box body 10, and battery cells 20 arranged in an array are disposed in the box body 10. The electric control assembly 30 is connected to the battery cells 20, and the electric control assembly 30 is a battery management system.

The power-consuming component includes a bracket 31. A circuit board is disposed on a side that is of the bracket 31 and that is away from the battery cell 20, and the heat insulation plate 32 is disposed on a side that is of the bracket 31 and that faces the battery cell 20.

The bracket 31 includes the bracket body 311, and the circuit board is disposed on the side that is of the bracket body 311 and that is away from the battery cell 20. The side that is of the bracket body 311 and that faces the battery cell 20 is provided with the protruding structure 312. The protruding structure 312 includes a plurality of first reinforcing ribs 3121 and a plurality of second reinforcing ribs 3122. The length direction of the first reinforcing ribs 3121 is parallel to the width direction Y of the electric control assembly 30, and the first reinforcing ribs 3121 are spaced apart in the length direction X of the electric control assembly 30. The length direction of the second reinforcing ribs 3122 is parallel to the length direction X of the electric control assembly 30, and the second reinforcing ribs 3122 are spaced apart in the width direction Y of the electric control assembly 30. The first reinforcing ribs 3121 and the second reinforcing ribs 3122 cooperate with the bracket body 311 and a spacer plate to form a plurality of cavities 33.

Through holes 3123 are disposed on the first reinforcing ribs 3121 and the second reinforcing ribs 3122, so that each of the cavities 33 can directly or indirectly communicates with the space outside the electric control assembly 30, thereby enabling air to be exchanged and circulated between the cavities 33 and the space outside the electric control assembly 30.

The bracket 31 further includes the connecting structure 34, the connecting structure 34 includes the abutment 341 integrally formed with the bracket body 311. The side that is of the abutment 341 and that faces the heat insulation plate 32 is connected to the adhesive layer 342, and the adhesive layer 342 is connected to the heat insulation plate 32 to fix the heat insulation plate 32 to the bracket body 311. There are a plurality of connecting structures 34, and the plurality of connecting structures 34 are spaced apart at an edge of the bracket body 311. The connecting structure 34 is higher than the protruding structure 312, so that there is a gap between the heat insulation plate 32 and the protruding structure 312.

According to a second aspect, embodiments of the present application provide an energy storage device. The energy storage device includes the battery device 100 provided in some embodiments according to the first aspect.

Specifically, the energy storage device includes one or more battery clusters to increase a voltage and a capacity of the energy storage device. The battery cluster may include a plurality of battery cells 20, and the plurality of battery cells 20 are connected in series via a bus component to increase the voltage of the energy storage device. When the energy storage device comprises a plurality of battery clusters, the plurality of battery clusters are connected in parallel to increase the capacity of the energy storage device.

The energy storage device may be used in an energy storage power station, a wind power generation system, a solar power generation system, a mobile power system, a temporary power supply system, or the like. The energy storage device can store electrical energy as needed and output electrical energy at the appropriate time. For example, the energy storage device may store electric energy during periods of low power consumption, and provide electric energy for the relevant user or the electric apparatus during periods of peak power consumption. The energy storage system provided in the embodiments of the present application may be any power system that needs to use the energy storage device.

In some embodiments, the energy storage device is an energy storage container or an energy storage electric cabinet.

In some embodiments, the energy storage device may comprises a cabinet body and one or more battery clusters which are accommodated in the cabinet body.

In some embodiments, the energy storage device may comprise modules such as a thermal management module, a main control module, a general control module, a power distribution module, a fire protection module, etc.

As an example, the thermal management module may include a liquid cooling unit, and the liquid cooling unit provides a cooling liquid for adjusting the temperature of the battery cell 20 to each battery device 100 through a pipeline.

As an example, the main control module may be used as a battery management unit of the battery cluster to monitor and manage the battery cluster. The main control module may monitor information such as the current, voltage, power, or temperature of the battery cluster. For example, the charging and discharging current, voltage, and the like of the battery cluster may be controlled. The main control module includes modules such as a slave battery management unit (SBMU) and a fusion switch.

As an example, the general control module may be used as a battery management unit of the energy storage device to monitor and manage the energy storage device. The general control module may monitor information such as the current, voltage, power, state of charge, or temperature of the energy storage device. For example, the charging and discharging current, voltage, and the like of the energy storage device may be controlled. As an example, the general control module includes modules such as an insulation monitoring module (IMM), a master battery management unit (MBMU), an EtherNet (ETH), and a fiber optic conversion module.

As an example, the fire protection module comprises a control panel, a detector, an alarm device, and the like, and is used to perform detection, alarming, or extinguishment on the energy storage system.

As an example, the power distribution module may be used to distribute power to a module that requires power in the energy storage device.

According to a third aspect, some embodiments of the present application further provide an electric device, the battery device 100 provided in some embodiments according to the first aspect, or the energy storage device provided in some embodiments according to the second aspect. The battery device 100 is configured to store or provide electric energy.

Finally, it should be noted that, the foregoing embodiments are merely used to describe the technical solutions of the present application, but are not intended to limit the technical solutions of the present application. Although the present application is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions in the embodiments of the present application. All of the modifications or replacements shall fall within the scope of the claims and the specification of the present application. In particular, the technical features mentioned in the embodiments may be combined in any manner provided that no structural conflict is present. The present application is not limited to the specific embodiments disclosed herein, but includes all technical solutions falling within the scope of the claims.

## Claims

1. A battery device, comprising:
a box body;
a battery cell, accommodated in the box body; and
an electric control assembly, accommodated in the box body, wherein the electric control assembly comprises a bracket and an electric control component, the bracket comprises a bracket body, a side that is of the bracket body and that faces the battery cell is connected to a protruding structure, and a side that is of the bracket body and that is away from the battery cell is provided with the electric control component; and
the electric control assembly further comprises a heat insulation plate disposed on the side that is of the bracket body and that faces the battery cell, and the heat insulation plate, the bracket body, and the protruding structure enclose to form a cavity.

2. The battery device according to claim 1, wherein the protruding structure comprises a first reinforcing rib connected to the bracket body.

3. The battery device according to claim 2, wherein the protruding structure further comprises a second reinforcing rib connected to the bracket body, and the second reinforcing rib intersects the first reinforcing rib.

4. The battery device according to claim 3, wherein there are at least two first reinforcing ribs, and the first reinforcing ribs are spaced apart in a first direction; and
there are at least two second reinforcing ribs, the second reinforcing ribs are spaced apart in a second direction, and the second direction and the first direction are disposed with an included angle therebetween.

5. The battery device according to claim 4, wherein the first reinforcing rib and/or the second reinforcing rib are capable of separating the cavity into at least two sub-cavities; and
a through hole is provided on the first reinforcing rib and/or the second reinforcing rib, to implement communication between the sub-cavities on two sides of the through hole, and enable any one of the cavities to communicate with a space outside the electric control assembly.

6. The battery device according to claim 5, wherein the ratio of the dimension of a corresponding through hole to the dimension of an adjacent cavity ranges from 0.25 to 0.4 in the length direction of the first reinforcing rib or the second reinforcing rib.

7. The battery device according to any one of claims 1 to 6, wherein the electric control assembly further comprises a connecting structure, the connecting structure is disposed between the heat insulation plate and the bracket body, and the heat insulation plate is connected to the connecting structure; and
the heat insulation plate is connected to at least a part of the protruding structure, and/or, the heat insulation plate is spaced apart from at least a part of the protruding structure.

8. The battery device according to claim 7, wherein the area of a part that is of the connecting structure and that is connected to the heat insulation plate is larger than the area of a side that is of the protruding structure and that faces the heat insulation plate.

9. The battery device according to claim 7 or 8, wherein the dimension of the connecting structure is greater than the dimension of the protruding structure in an arrangement direction of the bracket body and the heat insulation plate.

10. The battery device according to claim 9, wherein the connecting structure comprises an abutment, and the abutment is connected to the bracket body; and
the connecting structure further comprises an adhesive layer, one side of the adhesive layer is connected to the abutment, and the other side of the adhesive layer is connected to the heat insulation plate.

11. The battery device according to claim 10, wherein the dimension of the abutment is less than or equal to the dimension of the protruding structure in the arrangement direction of the bracket body and the heat insulation plate.

12. The battery device according to claim 11, wherein a difference between the dimension of the abutment and the dimension of the protruding structure ranges from 1 mm to 2 mm in the arrangement direction of the bracket body and the heat insulation plate.

13. The battery device according to claim 9, wherein the connecting structure comprises an adhesive layer, one side of the adhesive layer is connected to the bracket body, and the other side of the adhesive layer is connected to the heat insulation plate.

14. The battery device according to any one of claims 10 to 13, wherein the dimension of the adhesive layer ranges from 1.2 mm to 2.2 mm in the arrangement direction of the bracket body and the heat insulation plate.

15. The battery device according to any one of claims 9 to 14, wherein a difference between the dimension of the connecting structure and the dimension of the protruding structure is less than or equal to 0.2 mm in the arrangement direction of the bracket body and the heat insulation plate.

16. The battery device according to any one of claims 7 to 15, wherein there are at least two connecting structures.

17. The battery device according to any one of claims 7 to 16, wherein the connecting structure is located at an edge of the bracket body.

18. The battery device according to any one of claims 1 to 17, wherein the dimension of the heat insulation plate ranges from 0.5 mm to 1 mm in the arrangement direction of the bracket body and the heat insulation plate.

19. The battery device according to any one of claims 1 to 18, wherein the electric control assembly further comprises a thermal conductive structure connected to the heat insulation plate, and at least a part of the thermal conductive structure is accommodated in the cavity.

20. The battery device according to claim 19, wherein the thermal conductive structure is connected to the box body.

21. The battery device according to any one of claims 1 to 20, wherein the material of the bracket body comprises at least one of plastic, resin, or rubber.

22. The battery device according to claim 21, wherein the electric control assembly further comprises an outer housing connected to the bracket body, and the electric control component is located in the outer housing; and
the outer housing and the bracket body are of an integrally injection-molded structure.

23. The battery device according to any one of claims 1 to 22, wherein the electric control assembly is disposed on a side that is of the battery cell and that is provided with a pressure relief structure.

24. An energy storage device, comprising the battery device according to claims 1 to 23, wherein the battery device is used to store or provide electric energy.

25. An electric device, comprising the battery device according to any one of claims 1 to 23 or the energy storage device according to claim 24, wherein the battery device is used to store or provide electric energy.
